# EUROPEAN PATENT SPECIFICATION

(11) **EP 0 682 362 B1**
(45) Date of publication and mention of the grant of the patent: **04.08.1999**
(21) Application number: 95107271.9
(22) Date of filing: 12.05.1995
(51) Int. Cl.: H01L 21/336, H01L 29/78, H01L 21/8249

(54) **Method of manufacturing semiconductor device including a DMOS transistor**
Herstellungsverfahren für ein Halbleiterbauelement mit DMOS-Transistor
Procédé de fabrication d'un dispositif semi-conducteur avec un transistor DMOS

(30) Priority: 13.05.1994 JP 9940994
(43) Date of publication of application: 15.11.1995
(73) Proprietor: FUJI ELECTRIC CO. LTD., Kawasaki 210 (JP)
(72) Inventor: Kitamura, Mutsumi, Kawasaki-ku, Kawasaki 210 (JP); Fujishima, Naoto, Kawasaki-ku, Kawasaki 210 (JP)
(74) Representative: Hoffmann, Eckart, Dipl.-Ing.

(56) References cited:
- EP-A- 0 484 321
- EP-A- 0 653 786
- ONDE ELECTRIQUE, vol. 67, no. 6, 1 November 1987, pages 58-69, XP000111247 ROSSEL P: "M.O.S. TECHNOLOGIES FOR SMART POWER AND HIGH-VOLTAGE CIRCUITS"

## Description

The present invention relates to a method of manufacturing a semiconductor device and, more particularly, to a BiCMOS processing technique for forming a power MOS transistor, a bipolar transistor and a CMOS transistor on a common chip (the same substrate).

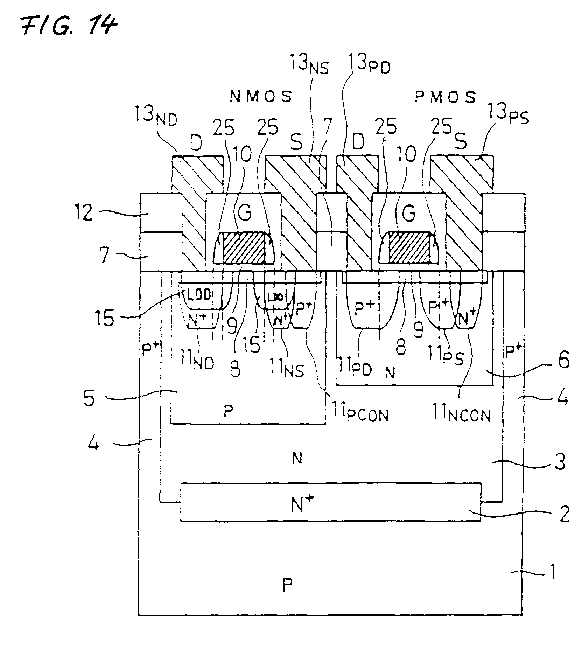

Figure 14 shows a CMOS (complementary insulated-gate field effect transistor) portion with low withstand voltage of a BiCMOS semiconductor device which has a double-well (twin-tub) structure. In Fig. 14, the CMOS portion is comprised of an N⁺ type buried layer 2 formed on a P type semiconductor substrate 1; an N type epitaxial layer 3 grown over the buried layer 2; an isolated element island isolated by P⁺ type isolation layers 4, 4 which reach the P type substrate 1; and double wells (a P type well 5 and an N type well 6) formed in the element island by implanting ions for forming the P type well 5 and the N type well 6 and by subsequent well-diffusion. After the double-well formation, a CMOS transistor is formed in the CMOS portion through the following steps. An active region is covered, for example, by a nitride film etc., and then an element-isolating insulation film (local oxide film: LOCOS) 7 is formed on the P⁺ type isolation layers 4, 4 and on a non-well portion between the P and N type wells 5 and 6 by selectively oxidizing the nitride film. A channel ion-implanted layer 8 is formed by implanting acceptor type (P type) impurities such as BF₂ (boron difluoride) etc. very shallowly from the surfaces of the wells 5 and 6. Poly-silicon gate electrodes 10, 10 are formed on a gate insulation film 9 deposited on the wells 5 and 6. N type low impurity concentration regions (LDD: Lightly doped drain) 15, 15 are formed by implanting N type impurities such as phosphor etc. using the gate electrode 10 on the P type well 5 as a mask for self-alignment. Side walls 25 are formed on the side faces of the gate electrodes 10, 10 by depositing an oxide film by the low temperature CVD method (at 815°C) and by subsequent etching. A P⁺ type source region 11_{PS} and a P⁺ type drain region 11_{PD} are formed by the self-alignment technique using the gate electrode 10 and the side walls 25, 25 on the N type well 6 as masks. Through this step, a P⁺ type well-contact region 11_{PCON} is formed simultaneously on the source side in the P type well 5. Then, an N⁺ type source region 11_{NS} and an N⁺ type drain region 11_{ND} are formed by self-alignment using the gate electrode 10 and the side walls 25, 25 on the P type well 5 as masks. Through this step, an N⁺ type well-contact region 11_{NCON} is formed simultaneously on the source side in the N type well 6. Then, inter-layer insulation film 12 is formed, and, finally, source electrodes 13_{NS}, 13_{PS} and drain electrodes 13_{ND}, 13_{PD}, which fill contact holes opened through the insulation film 12, are deposited.

By adopting the LDD structure for the N-channel MOSFET of the CMOS portion, an electric field is relaxed in the drain regions, and hot carrier injection into the gate insulation film 9 is greatly reduced. Due to this, the gate insulation film 9 is prevented from deteriorating with elapse of time and the reliability of the gate insulation film 9 is improved. Though Fig. 14 shows the CMOS portion with the LDD structure which has the side walls 25 on both sides of the gate electrodes 10, 10, some BiCMOSs are comprised of a CMOS portion, which lacks the side walls 25, without the LDD structure. And, another process sequence may be adopted which forms the P⁺ type source region 11_{PS} and drain region 11_{PD} using the gate electrode 10 as a mask for self-alignment in advance to the formation of side walls 25.

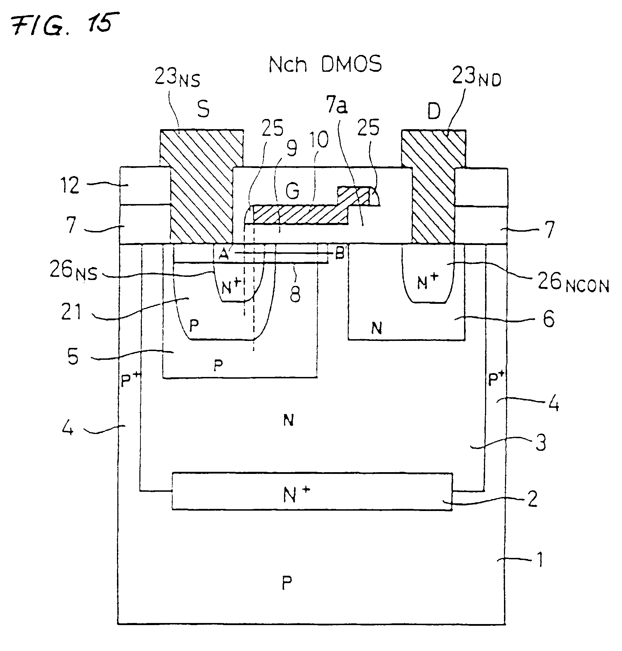

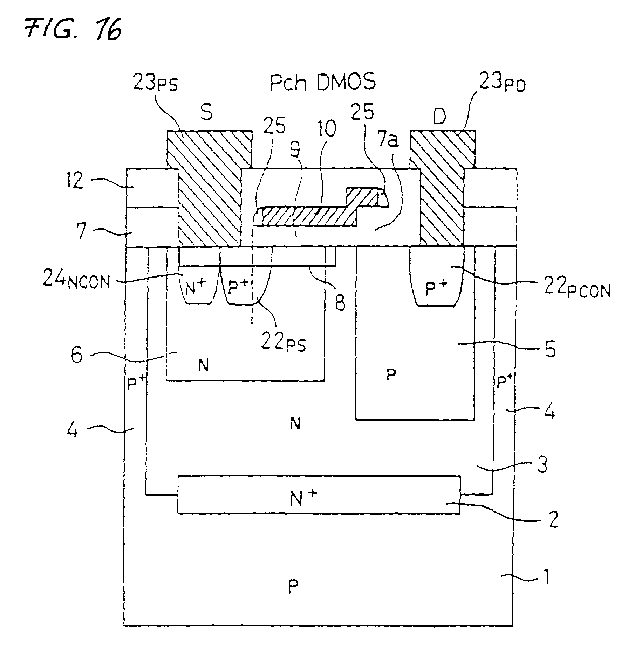

Figures 15 and 16 show structures of a high-withstand voltage DMOS portion (double-diffusion type insulated gate field effect transistor) as a power MOS portion. A P type well 5 and an N type well 6 of the N-channel type DMOSFET shown in Fig. 15 are formed through similar steps to those for the CMOS portion. The N type well 6 constitutes an offset region which functions as an expanded drain for reducing the ON-resistance of the MOSFET. An active region is covered, for example, by a nitride film, and then element-isolating insulation film (LOCOS) 7 is formed over P⁺ type element isolation layers 4, 4, and thick local oxide film 7a on the P type well side on the N type well 6 by selectively oxidizing the nitride film. A channel ion-implanted layer 8 is formed by implanting acceptor type (P type) impurities such as BF₂ etc. very shallowly from a surface of the P type well 5. A gate electrode 10 is formed on gate insulation film 9 deposited on the P type wells 5. A P type base region 21 is formed in the P type well 5 by using the gate electrode 10 as a mask for self-alignment. Base driving-in is employed for deeply diffusing the P type base region 21, for example, at 1100°C for 20 min or at 900°C for 60 min. The deep diffusion of the P type base region 21 contributes to increasing the withstand voltage of the high withstand voltage MOSFET. After the P type base region 21 is formed, side walls 25, 25, comprised of an oxide film deposited by the CVD method, are formed. After the side walls 25, 25 are formed, an N⁺ type source region 26_{NS} is formed self-aligned in the heavily doped P type base region 21 and an N⁺ type well-contact region 26_{NCON} in the N type well 6 by double diffusion using the gate electrode 10 and the side walls 25, 25. Then, contact holes are opened through inter-layer insulation film 12, and a source electrode 23_{NS} and a drain electrode 23_{ND} are deposited. The thick local oxide film 7a contributes to relaxing electric field localization onto the edge of the drain and therefore to realizing high withstand voltage.

In the P type well 5, an N-channel DMOS structure is formed by the lateral diffusion length difference between the P type base region 21 and the N type source region 26_{NS}. Since the DMOS structure facilitates, as compared with the general CMOSs, lowering resistance of the P type base beneath the N⁺ type source region 26_{NS}, a parasitic transistor consisting of the N type source region 26_{NS}, the P type base region 21 and the N type well 6 hardly operates. Due to this, latching up of the DMOS is suppressed and the safe operation area of the DMOS is widened. And, since the N⁺ type source region 26_{NS} is surrounded by the heavily doped P type base region 21, punching through between the source and the drain is prevented, and, therefore, the withstand voltage of the DMOS is improved. In Fig 15, the N-channel DMOS with the side walls 25, 25 shown exemplarily may be replaced by an N-channel DMOS without the side walls 25, 25. Or, the N⁺ type source region 26_{NS} may be formed in advance to the formation of the side walls 25, 25.

Figure 16 is a sectional view of a P-channel DMOSFET of the DMOS portion of the BiCMOS at a time of its source and drain electrodes formation. In Fig. 16, a P type well 5 and an N type well 6 are formed through similar steps to those for the CMOS portion and the P type well 5 constitutes an offset region which functions as an expanded drain for reducing the ON-resistance of the MOSFET. At first, an active region is covered by a nitride film etc., and then element-isolating insulation film 7 is formed on P⁺ type element isolation layers 4, 4, and thick local oxide film 7a on the N type well side on the P type well 5 by selectively oxidizing the nitride film. A channel ion-implanted layer 8 is formed by implanting acceptor type (P type) impurities such as BF₂ etc. very shallowly from a surface of the N type well 6. A gate electrode 10 is formed on a gate insulation film 9 deposited on the N type well 6. Side walls 25, 25, comprised of an oxide film deposited by the CVD method, are formed on both side faces of the gate electrode 10. Then, a P⁺ type source region 22_{PS} is formed self-aligned in the N type well 6 by using the gate electrode 10 as a mask, and P⁺ type well-contact region 22_{PCON} in the P type well 5. Then, an N⁺ type well-contact region 24_{NCON} is formed in the N type well 6. Then, contact holes are opened through inter-layer insulation film 12, and a source electrode 23_{PS} and a drain electrode 23_{PD} are deposited. The thick local oxide film 7a contributes to increase the withstand voltage by relaxing electric field localization onto the edge of the drain.

The side walls 25, 25 may be omitted, or the P⁺ type source region 22_{PS} may be formed prior to the formation of the side walls 25, 25. In Fig. 16, in which the P⁺ type source region 22_{PS} and the N type well 6 constitute a DMOS structure, the P⁺ type source region 22_{PS} is formed self-aligned by masking of the side walls 25, 25 and the lateral diffusion length of the heavily doped P⁺ type source region 22_{PS} is shorter by the length (width) of the side wall 25 as compared with a DMOS structure without the side walls 25, 25. Since the total donor impurity concentration in the surface layer of the N type well 6 beneath the gate electrode 10 can be increased due to the shorter diffusion length, withstand voltage lowering caused by surface punching through is suppressed and larger current capacity of the DMOS is facilitated.

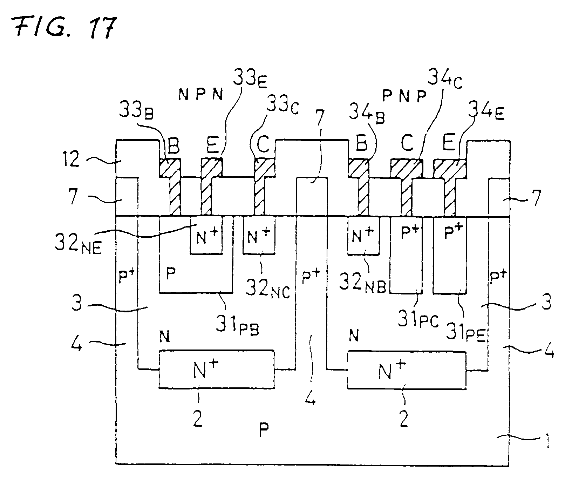

The bipolar transistor portion of the BiCMOS semiconductor device is comprised of a vertical NPN transistor and a lateral PNP transistor as shown in Fig. 17. Through processing steps similar to those for forming the CMOS portion, an N⁺ type buried layer 2 is formed on a P type substrate 1, an N type epitaxial layer 3 is grown over the buried layer 2, and then, P⁺ type element isolation layers 4, 4, 4 which reach the substrate 1 are formed to isolate element islands. In fabricating the horizontal NPN transistor, a P type base region 31_{PB} is formed in the N type epitaxial layer 3, and then, an N⁺ type emitter region 32_{NE} and an N⁺ type collector region 32_{NC} are formed. After opening contact holes through inter-layer insulation film 12, a base electrode 33_{B}, an emitter electrode 33_{E}, and a collector electrode 33_{C} are formed. In fabricating the lateral PNP transistor, a P⁺ type emitter region 31_{PE} and a P⁺ type collector region 31_{PC} are formed in the N type epitaxial layer 3 by employing the step for forming the P type base region 31_{PB} of the horizontal transistor, and then, N⁺ type base region (base-contact) 32_{NB} is formed. Then, after opening contact holes through inter-layer insulation film 12, a base electrode 34_{B}, an emitter electrode 34_{E}, and a collector electrode 34_{C} are formed.

The BiCMOS structure according to the prior art which is comprised of the above described DMOS portion as the power MOS portion poses the following problems.

Since the CMOS, the bipolar transistor and the DMOS portions are formed on a common substrate, the BiCMOS is manufactured through many steps in a long processing time with high manufacturing cost.

Since the base region of the second conductivity type (for example P type) of the high-withstand voltage DMOS portion is formed by employing the step for forming the base region of the second conductivity type of the bipolar transistor, ions are implanted in the base region of the DMOS portion at a relatively low dose amount so as not to lower the current amplification factor h_{FE} of the bipolar transistor. Because of this, the base drive-in heat treatment becomes necessary to increase the withstand voltage of the high withstand voltage DMOS portion.

EP-A-0 653 786 (prior art according to Art. 54(3) EPC) discloses a method of manufacturing a semiconductor device, including a DMOS transistor with a channel of a first conductivity type, comprising the following steps for forming said DMOS transistor: forming a gate electrode on a gate insulation film deposited on a semiconductor region of a second conductivity type; forming a base region of the second conductivity type by using said gate electrode as a mask for self-alignment; forming side walls on side faces of said gate electrode; and forming a source region of the first conductivity type from a major face of said base region using said side walls as a mask for self-alignment. The side walls are formed by depositing oxide films by a CVD technique and a high-temperature heat-treatment for driving-in the base region is eliminated.

EP-A-0 484 321 discloses a method of manufacturing a DMOS comprising: forming a gate electrode on a gate insulation film deposited on an n type semiconductor region; forming a p type base region by using said gate electrode as a mask for self-alignment; driving-in the base region by means of a heat-treatment; forming side walls on side faces of said gate electrode; and forming an n type source region from a major face of said base region using said side walls as a mask for self-alignment.

P. Rossel "M.O.S. technologies for smart power and high-voltage circuits" in L'Onde Electrique. 67 (1987). Nov.. No. 6. pages 58-69 discloses a BiCMOS semiconductor device including a DMOS.

An object of the present invention is to provide a manufacturing method which facilitates manufacturing a semiconductor device through less processing steps in a shorter period of time.

This object is achieved with a method as claimed in claims 1 and 2, respectively. Preferred embodiments of the invention are subject-matter of the dependent claims.

The object of the present invention is achieved by eliminating the base drive-in step required only for the high withstand voltage DMOS portion. In general, when a P type impurity (the second conductivity type) such as boron is diffused in a region already heavily doped with an N type (the first conductivity type) impurity such as arsenic, diffusion of the P type impurity is considerably suppressed. Therefore, if ion-implantation is conducted for the source region of the first conductivity type after ion-implantation for the base region of the second conductivity type, diffusion of the impurity of the second conductivity type for forming the base region will be suppressed, because the dose amount of the impurity of the first conductivity is large. Thus, the total impurity amount in the base region is limited and lower withstand voltage may be caused. To avoid this problem, the base drive-in step, which is a heat treatment step for sufficiently diffusing the impurity, has been adopted in the base region formation. The present invention utilizes the side wall formation conducted between the base region formation and the source region formation in place of the base drive-in step.

The manufacturing method of the present invention for manufacturing a semiconductor device which includes a DMOS transistor with a channel of a first conductivity type reduces the manufacturing steps by employing the side wall formation step to base formation for the substitution of the base drive-in step which is necessary only for forming the high withstand voltage DMOS portion. Since the drive-in by heat treatment for expanding the base region as deeply as necessary is almost satisfactorily replaced by the side wall formation, insufficient depth of the base region which lowers the withstand voltage is not caused. Sufficient heat treatment effect is obtained by forming the side walls by thermal oxidation or by CVD under reduced pressure.

When the semiconductor device is a CMOS semiconductor device, the manufacturing steps are reduced by forming the CMOS portion in an LDD structure and by employing its side wall formation step for the side wall formation of the DMOS portion. As a matter of course, the LDD structure facilitates integrating the CMOS portion and the DMOS portion into a monolithic circuit. The LDD structure also facilitates preventing hot carriers from being injected into the gate insulation film of the CMOS portion and improves the reliability of the CMOS transistor. The manufacturing steps are also reduced by employing the CMOS processing steps for forming the well of the second conductivity type, the source of the second conductivity type and the drain of the second conductivity type and the steps for forming the source of the first conductivity type and the drain of the first conductivity type to the DMOS processing steps for forming the well of the second conductivity type, the base of the second conductivity type, and the source of the first conductivity type. In so far as the CMOS is concerned, since the drive-in time for the channel is short and since, due to this, the surface impurity concentration remains high, the dose amount may be lowered in correspondence with the high surface impurity concentration.

When the semiconductor device is a BiCMOS semiconductor device, the manufacturing steps are reduced by employing the steps for forming the base region of the second conductivity type and the emitter region of the first conductivity type of the bipolar transistor for forming the base region of the second conductivity type and the source region of the first conductivity type of the CMOS transistor. In so far as the bipolar transistor is concerned, since the base region of the second conductivity type is shallowly diffused, the current amplification factor h_{FE} is improved.

The manufacturing method of the present invention for manufacturing a semiconductor device which includes a DMOS transistor with a channel of the second conductivity type reduces the manufacturing steps by employing the side wall formation step for the base drive-in step necessary for forming the high withstand voltage DMOS portion. Since the drive-in by heat treatment for expanding the base region as deeply as necessary is almost satisfactorily replaced by the side wall formation, insufficient depth of the base region which lowers the withstand voltage is not caused. Sufficient heat treatment effect is obtained by forming the side walls by thermal oxidation or by CVD under reduced pressure.

As described earlier, when the semiconductor device is a CMOS semiconductor device, by forming the CMOS portion in an LDD structure and by employing its side wall formation step for the side wall formation of the DMOS portion, the manufacturing steps are reduced and the reliability of the CMOS portion is improved. The manufacturing steps are also reduced by employing the CMOS processing steps for the source of the first conductivity type and the drain of the first conductivity type, and the steps for forming the source of the second conductivity type and the drain of the second conductivity type as the DMOS processing steps for forming the base of the first conductivity type, and the source of the second conductivity type.

As described earlier, when the semiconductor device is a BiCMOS semiconductor device, the manufacturing steps are reduced by employing the steps for forming the base region of the first conductivity type and the emitter region of the second conductivity type of the bipolar transistor as the steps for forming the base region of the first conductivity type and the source region of the second conductivity type of the DMOS transistor. In so far as the bipolar transistor is concerned, since the base region of the first conductivity type is shallowly diffused, the current amplification factor h_{FE} is improved.

When the semiconductor device is a CMOS semiconductor device, the withstand voltage of the DMOS transistor is improved by forming its P type base region as deeply as possible by implanting the impurity in the P⁺ type source and drain of the CMOS portion, and then by implanting the impurity in the N⁺ type source and drain of the CMOS portion.

And, the withstand voltage of the DMOS transistor is further improved by implanting the impurity in the P⁺ type source and drain at the dose amount lower than usual, e.g. around 1x10¹⁴cm⁻².

Now the present invention will be described in detail hereinafter with reference to the drawings which illustrate preferred embodiments of the present invention.
- Fig. 1: is a sectional view showing the structure of an embodiment at gate electrode formation of the N-channel DMOSFET of the high withstand voltage DMOS portion in a BiCMOS process according to the present invention;
- Fig. 2: is a sectional view showing the structure at source and drain electrode formation of the N-channel DMOSFET of the high withstand voltage DMOS portion in the BiCMOS process according to the present invention;
- Fig. 3(a): is a graph showing the impurity distribution on the horizontal section along the line A'-B' of the prior art in Fig. 15;
- Fig. 3(b): is a graph showing the impurity distribution on the horizontal section along the line A-B of Fig. 2;
- Fig. 4: is a graph showing the impurity distribution on the section along the line A-B in Fig. 2 of the high withstand voltage DMOS portion, the side walls of the gate electrode of which are formed by the CVD method under reduced pressure in the BiCMOS process according to the present invention;
- Fig. 5: is a sectional view showing the structure of another embodiment at source and drain electrode formation of the N-channel DMOSFET portion of the high withstand voltage DMOS obtained by another BiCMOS process according to the present invention;
- Fig. 6: is a sectional view showing the structure at gate electrode formation of the P-channel DMOSFET portion of the high withstand voltage DMOS portion obtained by the BiCMOS process according to the present invention;
- Fig. 7: is a sectional view showing the structure at source and drain electrode formation of the P-channel DMOSFET portion of the high withstand voltage DMOS obtained by the BiCMOS process according to the present invention;
- Fig. 8: is a sectional view showing the structure of another embodiment at source and drain electrode formation of the P-channel DMOSFET portion of the high withstand voltage DMOS obtained by still another BiCMOS process according to the present invention;
- Fig. 9: is a sectional view showing the structure of still another embodiment at source and drain electrode formation of the P-channel DMOSFET portion of the high withstand voltage DMOS obtained by still another BiCMOS process according to the present invention;
- Fig. 10: is a sectional view showing the structure at source and drain electrode formation of the low withstand voltage CMOS portion obtained by the BiCMOS process according to the present invention;
- Fig. 11: is a sectional view showing the structure of another embodiment at source and drain electrode formation of the low withstand voltage CMOS portion obtained by another BiCMOS process according to the present invention;
- Fig. 12: is a sectional view showing the structure of an embodiment at electrode formation of the bipolar transistor obtained by the BiCMOS process according to the present invention;
- Fig. 13: is a sectional view showing the structure of another embodiment at electrode formation of the bipolar transistor in another BiCMOS process according to the present invention;
- Fig. 14: is a sectional view showing an exemplary structure at source and drain electrode formation of the low withstand voltage CMOS portion in the BiCMOS process according to the prior art;
- Fig. 15: is a sectional view showing an exemplary structure at source and drain electrode formation of the high withstand voltage DMOS portion of the BiCMOS according to the prior art;
- Fig. 16: is a sectional view showing another exemplary structure at source and drain formation of the high withstand voltage DMOS portion of the BiCMOS according to the prior art; and
- Fig.17: is a sectional view showing an exemplary structure at electrode formation of the bipolar transistor in the BiCMOS according to the prior art.

Table 1 lists the BiCMOS process sequences, in which an "x" indicates that the designated step is included. Though most of the process sequences are conducted from top to bottom of Table 1, step order may be changed in some sequences. And, some elements may be formed in the steps indicating otherwise; that is, for example, a source region may be formed in a step designated as "Base".

### N-channel MOSFET in high withstand voltage DMOS portion

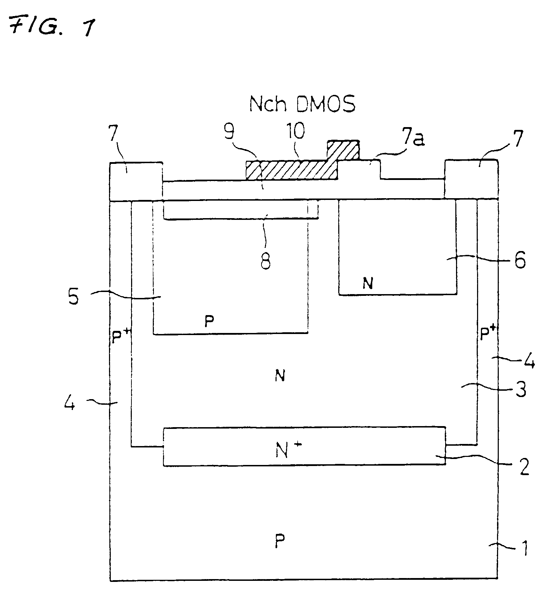

Figure 1 is a sectional view showing the structure of an embodiment at gate electrode formation of the N-channel DMOSFET of the high withstand voltage DMOS portion in the BiCMOS process according to the present invention. In the embodiment of the DMOS portion, as listed in table 1 and similarly as by the prior art, an N⁺ type buried layer 2 is formed on a P type semiconductor substrate 1. An N type epitaxial layer 3 is grown over the buried layer 2, and then, P⁺ type element isolation layers 4, 4 which reach the P type semiconductor substrate 1 are formed to isolate an element island. A P type well 5 and an N type well 6 are formed in the isolated element island by employing ion-implantation steps for P- and N well formation in the CMOS portion and by subsequent well diffusion. The N type well 6 functions as an offset region as an expanded drain for reducing the ON-resistance of the MOSFET. Then, an active region is covered, for example, by a nitride film, and element-isolating insulation film (LOCOS) 7 is formed on the P⁺ type element isolation layers 4, 4, and thick local oxide film 7a is formed on the side of the P type well 5 above the N type well 6 by selectively oxidizing the nitride film. Then, a channel ion-implanted layer 8 is formed by shallowly implanting impurities of the acceptor type (P type) such as BF₂ from the surface of the P type well 5. After forming the ion-implanted layer 8, a poly-silicon gate electrode 10 is formed on gate insulation film 9 and the local oxide film 7a.

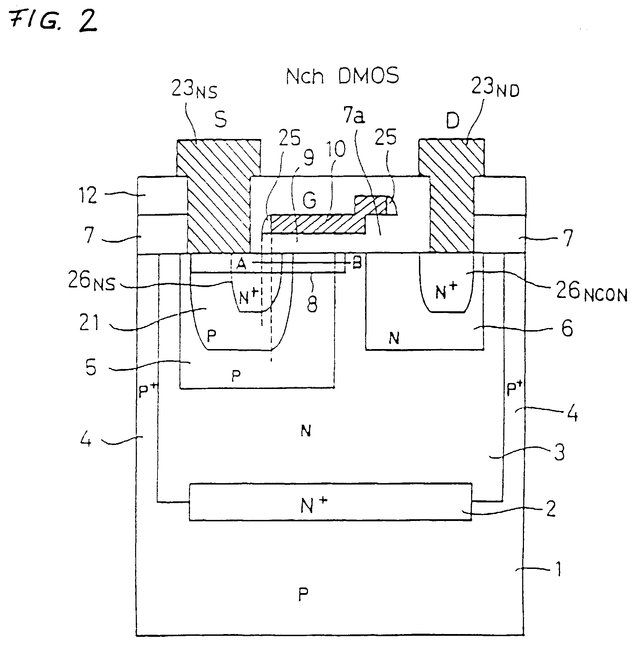

Figure 2 is a sectional view showing the structure of an embodiment at source and drain electrode formation of the N-channel DMOSFET of the high withstand voltage DMOS portion in the BiCMOS process according to the present invention. After the gate electrode 10 is formed, a P type base region (channel diffusion region) 21 is formed in the P type well 5 by employing a doping step of the bipolar transistor and by using the gate electrode 10 as a mask for self-alignment. After the P type base region 21 is formed, side walls 25, 25 of a thermal oxide film are formed on the side faces of the gate electrode 10 by an exclusive step or by employing a process for forming an LDD structure for the CMOS portion described later. After the side wall formation, an N⁺ type source region 26_{NS} is formed in the heavily doped P type base region 21 by double diffusion using the gate electrode 10 and the side wall 25 as a mask for self-alignment by employing the CMOS process for forming the N⁺ type source and drain. And, an N⁺ type well-contact region 26_{NCON} is formed in the N type well 6.

After forming inter-layer insulation film 12, contact holes are opened through the insulation film 12, and a source electrode 23_{NS} and a drain electrode 23_{ND} are formed. The thick local oxide film 7a relaxes electric field localization onto the edge of the drain and contributes to increasing the withstand voltage.

An N-channel type DMOS structure, formed by the lateral diffusion length difference between the P type base region 21 and N⁺ type source region 26_{NS} plus the thickness of the side wall 25, is formed as a channel diffusion region in the P type well 5. Since the DMOS structure usually facilitates reducing the P type base resistance beneath the N⁺ type source region 26_{NS} more than the usual CMOSs, a parasitic bipolar transistor comprised of the N type source region 26_{NS}, the P type base region 21 and the N type well (drain region) 6 hardly operates, which prevents latching up and facilitates widening the safe operation area. And, since the N⁺ type source region 26_{NS} is surrounded by the heavily doped P type base region 21, punching through between the source and the drain is prevented, and the withstand voltage increase is facilitated.

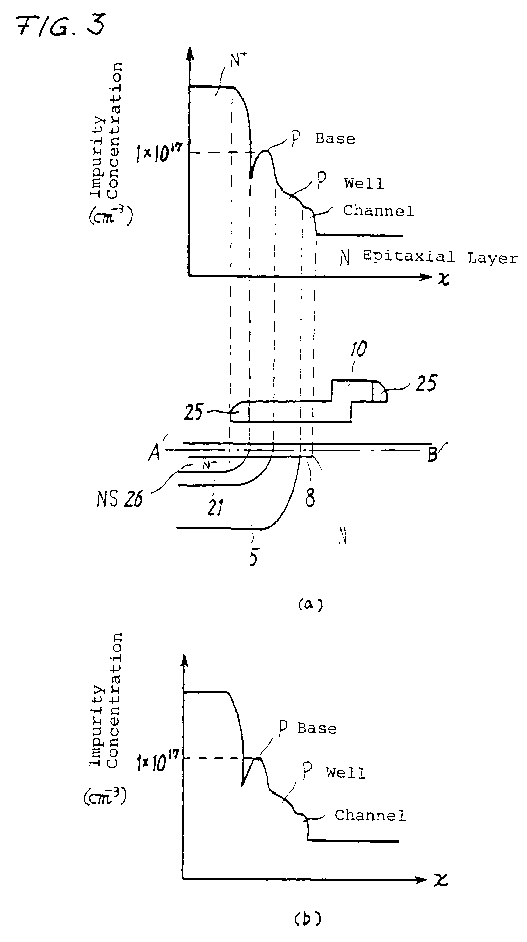

In this embodiment, the base drive-in step for forming the P type base region 21 deeply at 1100°C is omitted and the side walls are not formed by the CVD under reduced pressure. In this embodiment, the side walls are formed by the thermal oxidation at 900°C for 30 min. Impurity distribution along section A-B of the DMOS portion of Fig. 2, which omits the base drive-in step and forms the side walls by the CVD under reduced pressure, is shown in Fig. 3(a). Figure 3(b) shows impurity distribution along section A-B of the DMOS portion which forms the side walls by thermal oxidation. As to be taken from Figs. 3(a) and 3(b), almost the same impurity distribution is obtained by optimizing the conditions for the side wall formation even when the base drive-in step is omitted. Since the portion of the P type base region 21 beneath the gate electrode 10 functions as a channel, the portion should be doped to a certain dose level. It has been revealed experimentally that the withstand voltage is around 90 V at the optimum impurity concentration of 1x10¹⁷cm⁻³ and the withstand voltage is around 5 V at the impurity concentration of 5x10¹⁶cm⁻³. Figure 3(b) shows that the optimum impurity concentration of 1x10¹⁷cm⁻³ is obtained by forming the side walls by thermal oxidation without conducting base drive-in. That is, a similar excellent property is obtained even when the base drive-in step is omitted. Defects caused by the high temperature heat treatment are reduced by omitting the base drive-in step. When the oxide film is formed by thermal oxidation, the substrate is also oxidized. However, the side walls are formed on both side faces of the poly-silicon gate electrode 10, while the substrate is made of single crystal silicon. The growth rate of the oxide film in single crystal silicon is, though it depends on the conditions, about a half that of the poly-silicon. It has been known that the ratio of the consumed substrate thickness to the growing oxide film thickness is 0.44. Therefore, when a side wall is grown to a thickness of 120 nm, the thickness of the consumed substrate is only 26.4 nm (120x0.5x0.44 = 26.4 nm), which is not so thick as to badly affect the device properties.

The present embodiment reduces processing steps by employing the processing steps for the other portions. The P type well 5 and the N type well 6 are formed by employing the steps for P and N well formation in the CMOS portion; the P type base region 21 by employing the formation step for the P type base region of the bipolar transistor, the side walls 25, 25 by employing the process for forming the LDD structure for the CMOS portion; and the N⁺ type source region 26_{NS} by employing the steps for forming the N⁺ type source and drain of the CMOS portion.

The side walls may be formed by CVD under reduced pressure. However, it has been revealed experimentally that a low withstand voltage of around 5 V is obtained by the usual CVD method under reduced pressure (120nm in deposition thickness at 815°C for 60 min). To avoid the low withstand voltage and to obtain the maximum surface impurity concentration of 1x10¹⁷cm⁻³ in the P type base region under the gate electrode, the CVD step is conducted at a temperature, e.g. 900°C, at which the diffusion coefficient of the N type impurity is large. Figure 4 shows impurity distribution along section A-B of the DMOS portion of Fig. 2 formed by another embodiment of the present invention which forms the side walls by CVD at 900°C for 30 min. As Fig. 4 shows, the same impurity distribution as shown in Fig. 3(a) is obtained without any base drive-in step.

The N⁺ type source region 26_{NS}, formed in the above described embodiment by employing the step for forming the N⁺ type source and drain of the CMOS portion, may be formed also by employing the step for forming the N⁺ type emitter region of the bipolar transistor.

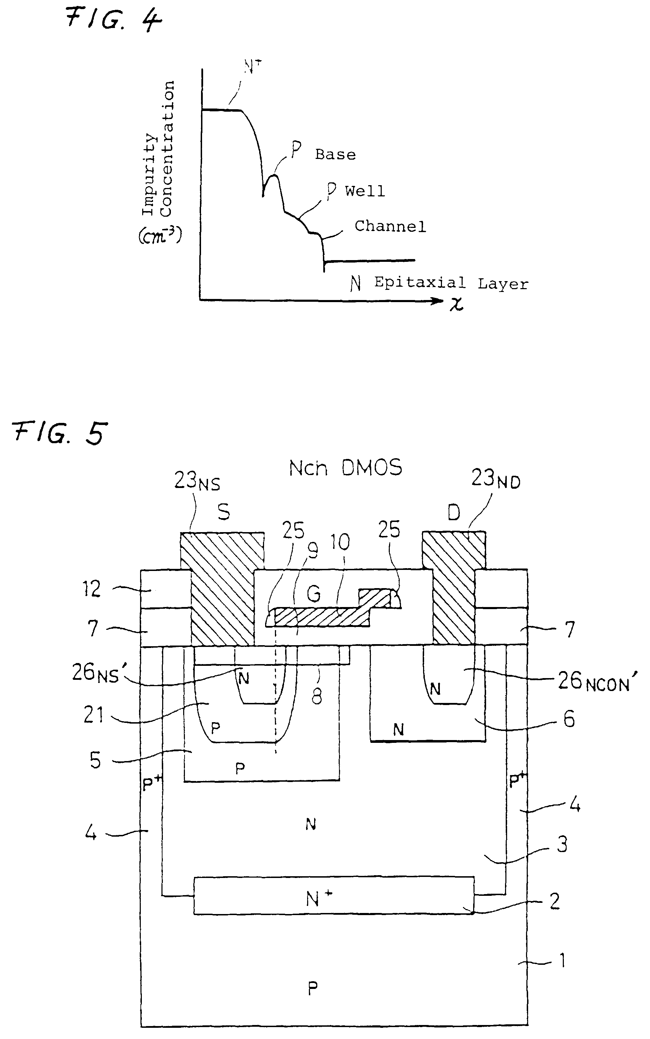

Alternatively, a step for exclusively forming the N⁺ type source may be inserted before the step for the P type base region 21 as the process sequence 2 of Table 1 describes. That is, as shown in Fig. 5, an N⁺ type source region 26_{NS}' is formed in the P type well 5 by an exclusive step for forming the N⁺ type source of the DMOS using the gate electrode 10 as a mask for self-alignment, and an N⁺ type well-contact region 26_{NCON}' in the N type well 6. Then, the P type base region 21 is formed by employing the step for forming the P type base region of the bipolar transistor using the gate electrode 10 as a mask for self-alignment. And, since the CMOS adopts the LDD structure, the contact holes are opened through the inter-layer insulation film 12 and the source electrode 23_{NS} and the drain electrode 23_{ND} are formed after the side walls 25, 25 are formed on both side faces of the gate electrode 10.

The impurity concentrations in the N⁺ type source region 26_{NS}' and the N⁺ type well-contact region 26_{NCON}' are lower than those in the N⁺ type source region 26_{NS} and the N⁺ type well-contact region 26_{NCON} shown in Fig. 2. Though the side wall 25 does not show any masking effect since the source region 26_{NS}' is formed in advance to the side wall formation, the length of the P type base region 21 in the total channel length can be set longer than that obtained by employing the CMOS process, since the impurity concentration in the N⁺ type source region 26_{NS}' can be controlled at the optimum value by the exclusive DMOS process. Therefore, the withstand voltage and the current capacity of the DMOS portion can be increased. And, since the P type base region 21 is formed by employing the step for forming the P type base region of the bipolar transistor in advance to the formation of the side wall 25, the DMOS structure which includes the N⁺ type source region 26_{NS}' and the P type base region 21 can be obtained in the P type well 5 beneath the gate electrode similarly as in the prior art even when the side wall 25 is formed in the DMOS portion as well as in the CMOS portion. Therefore, the DMOS portion and the CMOS portion which include the side walls can be integrated into a monolithic circuit.

The P type base region may be formed by slightly modifying the process sequences 3 so as to form the P⁺ type source and drain of the CMOS portion prior to the side wall formation and by employing the modified source and drain formation step for the CMOS portion. However, when the modified process is employed, the threshold value is increased and a sufficient current is not obtained due to the large dose amount of the P type impurities in the usual P⁺ type source and drain formation. To avoid this problem, P⁺ type impurity such as boron is implanted at the relatively lower dose level of e.g. 5x10¹⁴cm⁻². In this case, the order of ion-implantation is important, since the P type impurity and the N type impurity are successively implanted using the same mask. When priority is given to the property of the CMOS portion and the dose amount of the P type impurity is set at a high level, impurities are implanted in the order of from the N type to the P type. When priority is given to the property of the DMOS portion and the dose amount of the P type impurity is set at a low level, impurities are implanted in the order of from the p type to the N type. This is because implantation of impurities with large mass number such as arsenic causes defects in the substrate crystal and hinders deep diffusion of the impurity implanted next.

### P-channel MOSFET in high withstand voltage DMOS portion

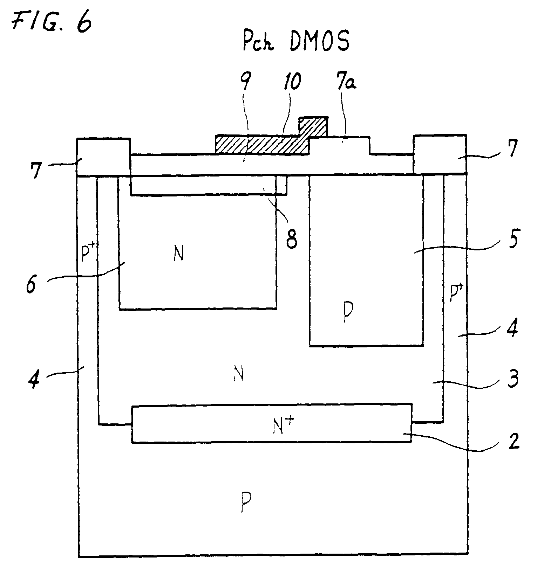

Figure 6 is a sectional view showing the structure of an embodiment at gate electrode formation of the P-channel DMOSFET of the high withstand voltage DMOS portion in the BiCMOS process according to the present invention. In the embodiment of the DMOS portion, as described by the sequence 8 of Table 1, an N⁺ type buried layer 2 is formed on a P type semiconductor substrate 1. An N type epitaxial layer 3 is grown over the buried layer 2, and then, P⁺ type element isolation layers 4, 4 which reach the P type semiconductor substrate 1 are formed to isolate an element island. A P type well 5 and an N type well 6 are formed in the isolated element island by ion-implantation for the P and N wells and by subsequent well diffusion. The P type well 5 provides an offset region which functions as an expanded drain for reducing the ON-resistance of the MOSFET. Then, an active region is covered with a nitride film, and element-isolating insulative film (LOCOS) 7 is formed on the P⁺ type isolation layers 4, 4, and thick local oxide film 7a is formed on the side of the N type well above the P type well 5 by selectively oxidizing the nitride film. Then, an ion-implanted layer 8 is formed by shallowly implanting impurities of the acceptor type (P type) such as BF₂ from the surface of the N type well 6. Then, a gate electrode 10 is formed on gate insulation film 9 and the local oxide film 7a.

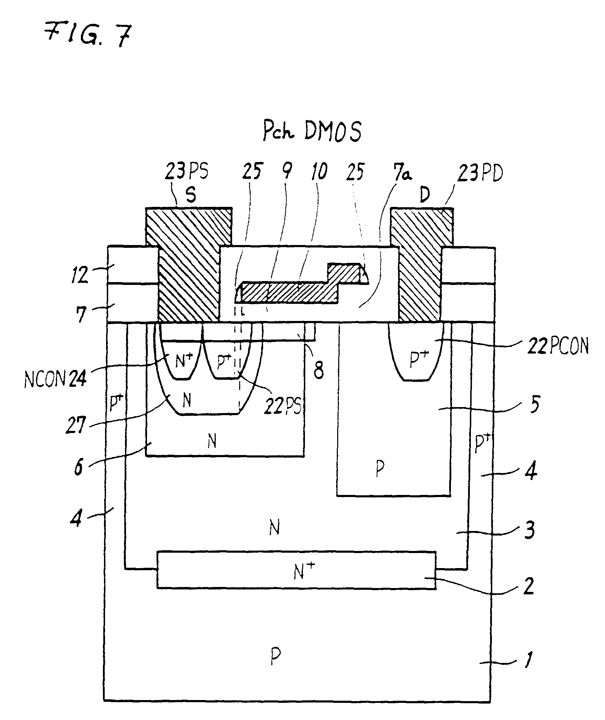

Figure 7 is a sectional view showing the structure of an embodiment at source and drain electrode formation of the P-channel DMOSFET of the high withstand voltage DMOS portion in the BiCMOS process according to the present invention. After the gate electrode 10 is formed, an N type base region 27 is doped by employing the step for the bipolar transistor using the gate electrode 10 as a mask for self-alignment. Then, side walls 25, 25 of an oxide film are formed by CVD under reduced pressure at 900°C for 30 min by an exclusive step or by employing the CMOS process for forming the LDD structure. According to the prior art, the side walls 25, 25 are formed by the CVD method under reduced pressure at a low temperature (815°C) after the base drive-in at 1100°C for 20 min in succession to the doping for the N type base region 27. The present invention omits the base drive-in step by rising the temperature of the CVD under reduced pressure. After the side wall formation, a P⁺ type source region 22_{PS} and a P⁺ type well-contact region 22_{PCON} are formed self-aligned by employing the step for forming the P⁺ type source and drain of the CMOS portion and by using the gate electrode 10 and the side walls 25, 25 as a mask. Then, an N⁺ type well-contact region 24_{NCON} is formed in the N type well 6 by employing the step for forming the N⁺ type source and drain of the CMOS portion. Then, contact holes are opened through insulation film 12 and a source electrode 23_{PS} and a drain electrode 23_{PD} are deposited. The thick local oxide film 7a relaxes electric field localization onto the drain edge and contributes to increasing the withstand voltage.

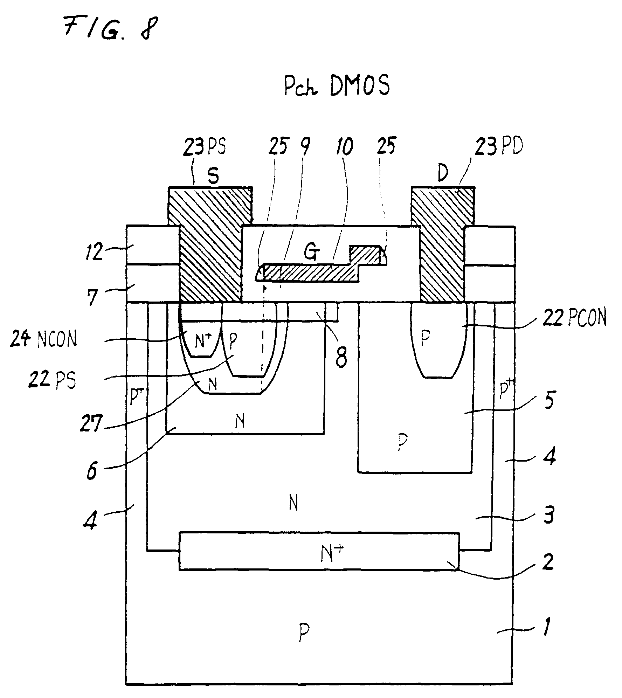

Figure 8 is a sectional view showing another embodiment of the P-channel DMOS transistor according to the present invention. Though the P⁺ type source region 22_{PS} and the P⁺ type well-contact region 22_{PCON} are formed by employing the step for forming the P⁺ type source and drain of the CMOS portion in the P-channel DMOS transistor shown in Fig. 7, a P⁺ type source region 22_{PS}' and a P⁺ type well-contact region 22_{PCON}' may be formed in advance to forming the side walls 25, 25 as shown in Fig. 8. That is, as the sequence 7 of Table 1 describes, the N type base region 27 is formed using the gate electrode 10 deposited in advance and a highly doped P⁺ type source region 22_{PS}' is formed self-aligned by employing the step for forming the P type region of the bipolar transistor. At the same time, the P⁺ type well-contact region 22_{PCON}' is formed in the P type well 5. Then, the side walls 25, 25 are formed for the sake of conformity with the CMOS process for forming the LDD structure. Then, the N⁺ type well-contact region 24_{NCON} is formed in the N type well 6 by employing the step for forming the N⁺ type source and drain of the CMOS portion. And, the contact holes are opened through the insulation film 12 and the source electrode 23_{PS} and the drain electrode 23_{PD} are deposited. Since the P⁺ type source region 22_{PS}' and the P⁺ type well-contact region 22_{PCON} are formed in advance to forming the side walls 25, 25 by employing the step for forming the P type base region of the bipolar transistor, a DMOS structure, comprised of the N type base region 27 beneath the gate electrode and the P⁺ type source region 22_{PS}' is obtained as in the prior art even when the side walls are formed in advance in the DMOS portion as well as in the CMOS portion. Because of this, the DMOS portion and the CMOS portion including the side walls can be integrated into a monolithic circuit.

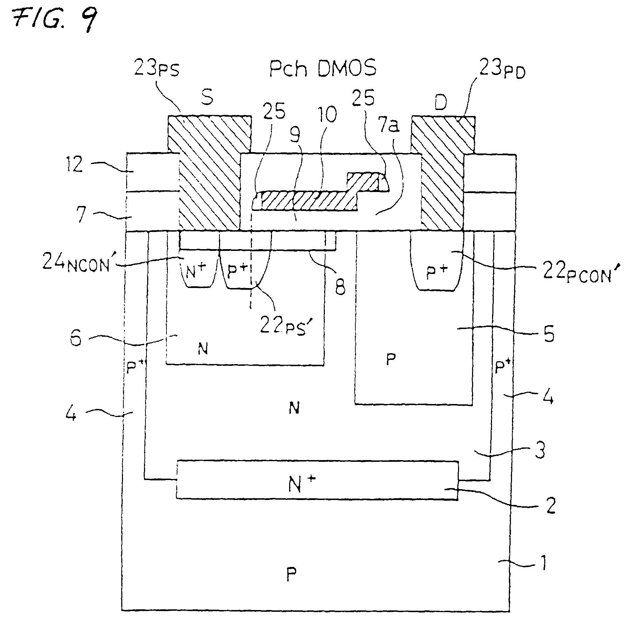

Figure 9 is a sectional view showing still another embodiment of the method for manufacturing a P-channel DMOS transistor according to the present invention. The method of Fig. 9 uses the sequence 6 of Table 1 and is different from the methods of Figs. 7 and 8 in that the N type base region 27 is not formed in Fig. 9. However, a DMOS structure is formed which comprises the P⁺ type source region 22_{PS}' formed by employing a CMOS process, and the N type well 6. Or, the P⁺ type source region 22_{PS}' may be formed according to the sequence 5 of Table 1 by employing the step for forming the P type base region of the bipolar transistor.

### CMOS portion with low withstand voltage

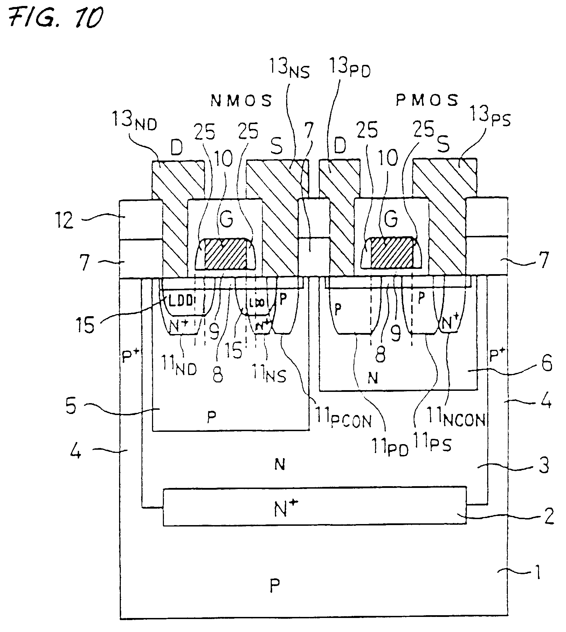

Figure 10 is a sectional view showing a CMOS portion of the BiCMOS according to the present invention. The method for manufacturing the CMOS portion will be explained with reference to Fig. 10. As described by the sequence 9 of Table 1, in Fig. 10, an N type epitaxial layer 3 is grown over an N⁺ type buried layer 2 formed on a P type semiconductor substrate 1. Then, an isolated element island is defined by forming P⁺ type element isolation layers 4, 4 which reach the P type semiconductor substrate 1. A P type well 5 and an N type well 6 are formed in the element island by ion-implantation for the P- and N wells and subsequent well diffusion. Then, an active region is covered by a nitride film etc., and element-isolating insulation film (LOCOS) 7 is formed on the P⁺ type isolation layers 4, 4 and above between the wells 5, 6 by selectively oxidizing the nitride film. Then, channel ion-implanted layers 8, 8 are formed by shallowly implanting impurities of the acceptor type (P type) such as BF₂ from the surface of the P type well 5 and the N type well 6. Then, poly-silicon gate electrodes 10, 10 are formed on gate insulation film 9 on the P type well 5 and the N type well 6. Then, lightly doped N type regions (LDD : lightly doped drain) 15, 15 are formed by implanting N type impurities such as phosphorus using the gate electrode 10 on the P type well 5 as a mask for self-alignment. Then, a P⁺ type well-contact region 11_{PCON} is formed in the P type well 5 by employing the step for forming the P type base region of the bipolar transistor. At the same time, a P⁺ type source region 11_{PS} and a P⁺ type drain region 11_{PD} are formed in the N type well 6 by using the gate electrode 10 on the N type well 6 as a mask for self-alignment. Then, an oxide film is deposited by CVD etc., and side walls 25, 25 and 25, 25 are formed on the side faces of the gate electrodes 10. Then, an N⁺ type source region 11_{NS} and an N⁺ type drain region 11_{ND} are formed in the P type well 5 by a self-alignment technique using the side walls 25, 25 and the gate electrode 10 as a mask. At the same time, N⁺ type well-contact region 11_{NCON} is formed in the N type well 6. After forming inter-layer insulation film 12, contact holes are opened through the insulation film 12, and then, source electrodes 13_{PS}, 13_{NS} and drain electrodes 12_{PD}, 13_{ND} are formed. Thus, by constructing the N-channel MOSFET of the DMOS portion in an LDD structure, an electric field in the drain is relaxed, hot carrier injection into the gate insulation film 9 is greatly suppressed, and reliability of the N-channel MOSFET is improved by preventing the gate insulation film 9 from deteriorating with elapse of time.

A step for forming exclusively the P⁺ type source and drain of the CMOS portion is eliminated from the above described steps for forming the LDD structure, which forms the P⁺ type well-contact region 11_{PCON} in the P type well 5 by employing the step for forming the P⁺ type base region of the bipolar transistor and self-aligns the P⁺ type source region 11_{PS} and the P⁺ type drain 11_{PD} in the N type well 6 by using its gate electrode 10 as a mask. Thus, a decrease in number of processing steps is realized even in constructing the LDD structure.

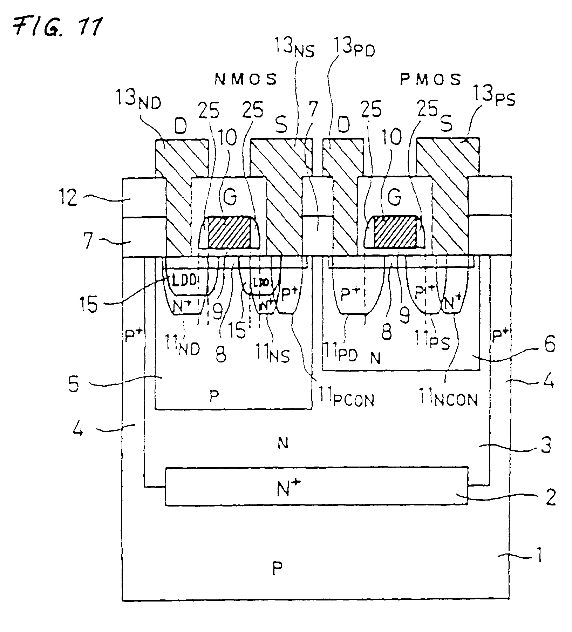

The P⁺ type well-contact region 11_{PCON}, the P⁺ type source region 11_{PS}, and the P⁺ type drain region 11_{PD} may be formed by employing the step for forming the P⁺ type source and drain of the CMOS portion as the sequence 10 of Table 1 describes. That is, as shown in Fig. 11, lightly doped N type regions 15, 15 are formed self-aligned by implanting N type impurities such as phosphorus using the gate electrode 10 on the P type well 5 as a mask, and then, side walls 25, 25, 25, 25 are formed on the side faces of the gate electrodes 10, 10. Then, an N⁺ type source region 11_{NS} and an N⁺ type drain region 11_{ND} are formed self-aligned in the P type well 5 by employing the step for forming the source 11 and drain of the CMOS portion and by using the side walls 25, 25 and the gate electrode 10 as a mask. At the same time, N⁺ type well-contact region 11_{NCON} is formed in the N type well 6. Then, a P⁺ type well-contact region 11_{PCON}, a P⁺ type source region 11_{PS}, and a P⁺ type drain region 11_{PD} are formed by employing the step for forming the P⁺ type source and drain of the CMOS portion. Since the N-channel MOSFET is formed in an LDD structure even by the manufacturing method of the prior art, hot carrier injection into the gate insulation film 9 is greatly suppressed, and reliability of the N-channel MOSFET is improved.

### Bipolar transistor

Finally, manufacturing steps for the bipolar transistor of the BiCMOS according to the present invention will be explained. The bipolar transistor is comprised of a horizontal NPN transistor and a lateral PNP transistor as shown in Fig. 12. By the similar steps as those for the CMOS portion, an N type epitaxial layer 3 is grown over an N⁺ type buried layer 2 formed on a P type substrate 1, and then, isolated element islands are defined by forming P⁺ type element isolation layers 4, 4, 4 which reach the P type semiconductor substrate 1. In manufacturing the horizontal NPN transistor, as the sequence 11 of Table 1 describes, a P type base region 31_{PB} is formed in the N type epitaxial layer 3. Then, an N⁺ type emitter region 32_{NE} and an N⁺ type collector region 32_{NC} are formed by employing the step for forming the N⁺ type source and drain of the CMOS portion. Then, after forming inter-layer insulation film 12, contact holes are opened through the insulation film 12, and a base electrode 32_{B}, an emitter electrode 32_{E} and a collector electrode 32_{C} are formed. And, in manufacturing the lateral PNP transistor, as the sequence 12 of Table 1 describes, an N⁺ type base region 32_{NB} is formed by employing the step for forming the N⁺ type source and drain of the CMOS portion, after forming in the epitaxial layer 3 a P type emitter region 31_{PE} and a P type collector region 31_{PC} by employing the step for forming the P type base region 31_{PB} of the horizontal transistor. Then, after forming the inter-layer insulation film 12, contact holes are opened through the insulation film 12, and a base electrode 34_{B}, an emitter electrode 34_{E} and a collector electrode 34_{C} are formed.

The step for forming the N⁺ type source and drain of the DMOS portion may be employed for forming the N⁺ type emitter region 32_{NE} and the N⁺ type collector region 32_{NC} of the NPN transistor as the sequence 13 of Table 1 describes. The step for forming the N⁺ type emitter region 32_{NE} and the N⁺ type collector region 32_{NC} of the horizontal NPN transistor may be employed for forming the N type base region (base contact region) 32_{NB} of the lateral PNP transistor as the sequence 16 of Table 1 describes. And, the P⁺ type emitter region 31_{PE} and the P⁺ type collector region 31_{PC} of the lateral NPN transistor may be formed by employing the step for forming the P⁺ type source and drain of the CMOS portion as sequence 10 of Table 1 describes.

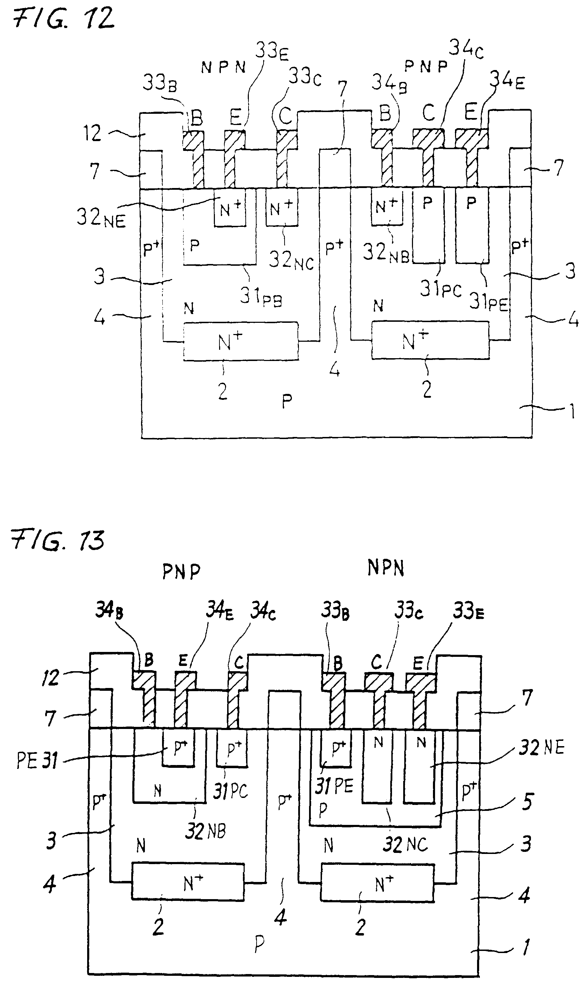

The bipolar transistor may be manufactured by the process sequences 15, 16 of Table 1. An N type epitaxial layer 3 is grown over an N⁺ type buried layer 2 formed on a P type substrate 1. P⁺ type element isolation layers 4, 4, 4 are formed and then a P type well 5 is formed. Then, an N type base region 32_{NB} of the PNP transistor is formed in the epitaxial layer 3. At the same time, an N⁺ type collector region 32_{NC} and an N⁺ type emitter region 32_{NE} of the NPN transistor are formed in the P type well 5. And, a P⁺ type emitter region 31_{PE} and a P⁺ type collector region 31_{PC} of the PNP transistor are formed by employing the step for forming the P⁺ type source and drain of the CMOS process. At the same time, a P⁺ type base contact region 31_{PB} of the NPN transistor is formed in the P type well 5. Then, contact holes are opened through the insulation film 12, and base electrodes 33_{B}, 34_{B}, emitter electrodes 33_{E}, 34_{E}, and collector electrodes 33_{C}, 34_{C} are formed. Thus, by employing the processing steps for forming the P type well and the N type base, a combination of a lateral NPN transistor and a horizontal PNP transistor having a configuration shown in Fig. 13 reversal to the configuration of Fig. 12 may be obtained. Other detailed variations may be facilitated.

Though the embodiments of present invention have been explained by reference to the junction separation scheme which separates the elements by the P⁺ type element isolation layers 4, 4 (or 4, 4, 4) after growing the epitaxial layer over the P type semiconductor substrate 1, the present invention is applicable also to the self-separation scheme which separates the elements by a P type or an N type semiconductor substrate. Also while formation of the N-channel DMOS and the P-channel DMOS have been separately described above a semiconductor device according to the invention may include both on the same chip.

As described above, the present invention is featured by the elimination of the base drive-in step exclusive for the DMOS portion and by the side wall formation which facilitates securing the maximum impurity concentration in the base region beneath the gate electrode in the DMOS portion. Therefore, the method of manufacturing a semiconductor device according to the present invention shows following effects.
(1) By optimizing the conditions for the side wall formation, the base drive-in step is eliminated. Due to this, the processing steps are reduced, the manufacturing period of time is shortened, and the manufacturing cost is reduced.
(2) By the elimination of the high temperature heat treatment step, defects and faults caused in the semiconductor devices by the heat treatment are reduced.
(3) When the semiconductor device is a CMOS semiconductor device, the processing steps are further reduced by forming the CMOS portion in an LDD structure and by employing the steps for forming the side walls, wells, source and drain of the CMOS transistor to the steps for forming side walls, wells, source and drain of the DMOS portion. And, the CMOS portion with the LDD structure can be integrated with the DMOS portion into a monolithic circuit. Moreover, since the gate insulation film of the CMOS portion is prevented from hot carriers injection, the reliability of the device is improved.
(4) When the semiconductor device is a BiCMOS semiconductor device, the processing steps are further reduced by employing the steps for forming the base region and the emitter region of the bipolar transistor to forming the base region, source region and drain region of the DMOS portion. And, since the light doping in the base region is facilitated, the current amplification factor h_{FE} of the bipolar transistor is improved.

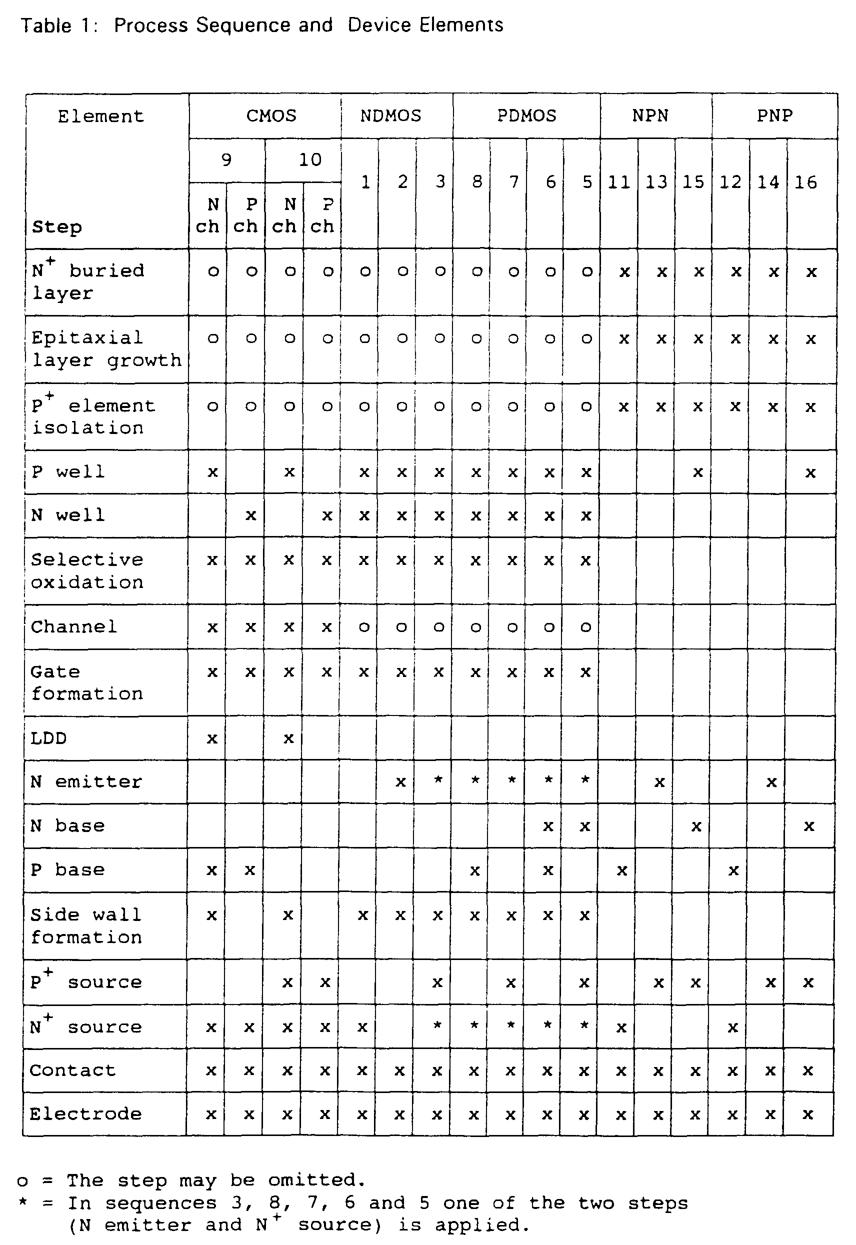

## Claims

1. A method of manufacturing a semiconductor device, including a DMOS transistor with a channel of a first conductivity type (N or P), comprising the following steps for forming said DMOS transistor:
(a) forming a gate electrode (10) on a gate insulation film deposited on a semiconductor region (5) of a second conductivity type (P or N);
(b) forming a base region (21, 27) of the second conductivity type (P or N) by using said gate electrode as a mask for self-alignment;
(c) forming side walls (25) on side faces of said gate electrode; and
(d) forming a source region (26_{NS}, 22_{PS}) of the first conductivity type (N or P) from a major face of said base region using said side walls as a mask for self-alignment,
wherein step (c) comprises forming said side walls (25) by thermal oxidation involving a heat-treatment sufficient to drive-in said base region.

2. A method of manufacturing a semiconductor device, including a DMOS transistor with a channel of a first conductivity type (N or P), comprising the following steps for forming said DMOS transistor:
(a) forming a gate electrode (10) on a gate insulation film deposited on a semiconductor region (5) of a second conductivity type (P or N);
(b) forming a base region (21, 27) of the second conductivity type (P or N) by using said gate electrode as a mask for self-alignment;
(c) forming side walls (25) on side faces of said gate electrode; and
(d) forming a source region (26_{NS}, 22_{PS}) of the first conductivity type (N or P) from a major face of said base region using said side walls as a mask for self-alignment,
wherein step (c) comprises forming said side walls (25) by a CVD method under reduced pressure involving a heat-treatment sufficient to drive-in said base region.

3. The method as claimed in claim 1 or 2 further including the step of forming a channel ion-implanted layer (8) by implanting P type impurity ions in the major surface region of said semiconductor region (5).

4. The method as claimed in claim 1, 2 or 3 further comprising the step of forming, as said semiconductor region (5) of said DMOS transistor, a well (5) of the second conductivity type in a semiconductor region (3) of the first conductivity type.

5. The method as claimed in claims 3 and 4 wherein said channel ion-implanted layer (8) is formed by implanting P type impurity ions from the major face of said well (5).

6. The method as claimed in any one of claims 1 to 5, wherein said semiconductor device further comprises a CMOS semiconductor device with CMOS transistors in an LDD structure formed on a common substrate (1) with said DMOS transistor and having side walls (25) on both side faces of a gate electrode (10) thereof, and said side walls (25) of said DMOS transistor are formed by employing a step for forming said side walls (25) of said CMOS transistor.

7. The method as claimed in claims 4 and 6, wherein said well (5) of said DMOS transistor is formed by employing a step for forming a well of the second conductivity type (P) of said CMOS transistor.

8. The method as claimed in claim 6 or 7, wherein said base region (21, 27) of said DMOS transistor is formed by employing a step for forming a source region and a drain region of the second conductivity type (P or N) of said CMOS transistor.

9. The method as claimed in any one of claim 1 to 8, wherein said semiconductor device further comprises a BiCMOS semiconductor device including CMOS transistors and a bipolar transistor formed on a common substrate with said DMOS transistor, and said base region of said DMOS transistor is formed by employing a step for forming a base region of the second conductivity type (P) of said bipolar transistor.

10. The method as claimed in claim 6 to 9, wherein said source region of said DMOS transistor is formed by employing a step for forming a source region and a drain region of the first conductivity type (N or P) of said CMOS transistor.

11. The method as claimed in claim 9, wherein said source region of said DMOS transistor is formed by employing a step for forming an emitter region of the first conductivity type (N) of said bipolar transistor.

12. The method as claimed in any one of claims 1 to 5, wherein said semiconductor device further comprises a BiCMOS semiconductor device including CMOS transistors and a bipolar transistor formed on a common substrate with said DMOS transistor, and said source region of said DMOS transistor is formed by employing a step for forming a base region of the second conductivity type (P) of said bipolar transistor.

13. The method as claimed in claim 12, wherein said source region of said DMOS transistor is formed by employing a step for forming an emitter region of the second conductivity type of said bipolar transistor.

14. The method as claimed in any one of claims 6 to 13, wherein ion-implantation is conducted for forming said source region of a P⁺ type and said drain region of the P⁺ type of said CMOS transistor, and then ion-implantation is conducted for forming said source region of an N⁺ type and said drain region of the N⁺ type of said CMOS transistor.

15. The method as claimed in any one of claims 6 to 14, wherein said base region of said DMOS transistor is formed by implanting ions at a dose amount of 5x10¹⁴cm⁻² or less.

## Patentansprüche

1. Verfahren zur Herstellung einer Halbleitervorrichtung, die einen DMOS-Transistor mit einem Kanal eines ersten Leitfähigkeitstyps (N oder P) aufweist, umfassend die folgenden Schritte zur Bildung des DMOS-Transistors:
(a) Bilden einer Gate-Elektrode (10) auf einem Gate-lsolierfilm, der auf einer Halbleiterzone (5) eines zweiten Leitfähigkeitstyps (P oder N) abgeschieden ist;
(b) Bilden einer Basiszone (21, 27) des zweiten Leitfähigkeitstyps (P oder N) unter Verwendung der Gate-Elektrode als Maske für die Selbstausrichtung;
(c) Bilden von Seitenwänden (25) an Seitenflächen der Gate-Elektrode; und
(d) Bilden einer Source-Zone (26_{NS}, 22_{PS}) des ersten Leitfähigkeitstyps (N oder P) aus einer Hauptfläche der Basiszone unter Verwendung der Seitenwände als Maske für die Selbstausrichtung,
wobei Schritt (c) die Bildung der Seitenwände (25) durch thermische Oxidation umfaßt, die eine Wärmebehandlung beinhaltet, die für das Eintreiben der Basiszone ausreicht.

2. Verfahren zur Herstellung einer Halbleitervorrichtung, die einen DMOS-Transistor mit einem Kanal eines ersten Leitfähigkeitstyps (N oder P) aufweist, umfassend die folgenden Schritte zur Bildung des DMOS-Transistors:
(a) Bilden einer Gate-Elektrode (10) auf einem Gate-lsolierfilm, der auf einer Halbleiterzone (5) eines zweiten Leitfähigkeitstyps (P oder N) abgeschieden ist;
(b) Bilden einer Basiszone (21, 27) des zweiten Leitfähigkeitstyps (P oder N) unter Verwendung der Gate-Elektrode als Maske für die Selbstausrichtung;
(c) Bilden von Seitenwänden (25) an Seitenflächen der Gate-Elektrode; und
(d) Bilden einer Source-Zone (26_{NS}, 22_{PS}) des ersten Leitfähigkeitstyps (N oder P) aus einer Hauptfläche der Basiszone unter Verwendung der Seitenwände als Maske für die Selbstausrichtung,
wobei Schritt (c) die Bildung der Seitenwände (25) durch ein CVD-Verfahren unter reduziertem Druck umfaßt, das eine Wärmebehandlung beinhaltet, die für das Eintreiben der Basiszone ausreicht.

3. Verfahren nach Anspruch 1 oder 2, ferner umfassend den Schritt der Bildung einer Kanalionenimplantationsschicht (8) durch Implantieren von P-Typ-Dotierstoffionen in die Hauptoberflächenzone der Halbleiterzone (5).

4. Verfahren nach Anspruch 1, 2 oder 3, ferner umfassend den Schritt der Bildung, als die Halbleiterzone (5) des DMOS-Transistors, einer Wanne (5) des zweiten Leitfähigkeitstyps in einer Halbleiterzone (3) des ersten Leitfähigkeitstyps.

5. Verfahren nach Anspruch 3 und 4, bei dem die Kanalionenimplantationsschicht (8) durch Implantieren von P-Typ-Dotierstoffionen von der Hauptfläche der Wanne (5) aus gebildet wird.

6. Verfahren nach einem der Ansprüche 1 bis 5, bei dem die Halbleitervorrichtung des weiteren eine CMOS-Halbleitervorrichtung mit CMOS-Transistoren in einer LDD-Struktur aufweist, die auf einem gemeinsamen Substrat (1) mit dem DMOS-Transistor gebildet sind und Seitenwände (25) an beiden Seitenflächen einer ihrer Gate-Elektroden (10) aufweisen, und bei dem die Seitenwände (25) des DMOS-Transistors unter Einsatz eines Schritts zur Bildung der Seitenwände (25) des CMOS-Transistors gebildet werden.

7. Verfahren nach Anspruch 4 und 6, bei dem die Wanne (5) des DMOS-Transistors unter Einsatz eines Schritts zur Bildung einer Wanne des zweiten Leitfähigkeitstyps (P) des CMOS-Transistors gebildet wird.

8. Verfahren nach Anspruch 6 oder 7, bei dem die Basiszone (21, 27) des DMOS-Transistors unter Einsatz eines Schritts zur Bildung einer Source-Zone und einer Drain-Zone des zweiten Leitfähigkeitstyps (P oder N) des CMOS-Transistors gebildet wird.

9. Verfahren nach einem der Ansprüche 1 bis 8, bei dem die Halbleitervorrichtung des weiteren eine BiCMOS-Halbleitervorrichtung umfaßt, die CMOS-Transistoren und einen Bipolartransistor enthält, die auf einem gemeinsamen Substrat mit dem DMOS-Transistor gebildet sind, und bei dem die Basiszone des DMOS-Transistors unter Einsatz eines Schritts zur Bildung einer Basiszone des zweiten Leitfähigkeitstyps (P) des Bipolartransistors gebildet wird.

10. Verfahren nach Anspruch 6 bis 9, bei dem die Source-Zone des DMOS-Transistors unter Einsatz eines Schritts zur Bildung einer Source-Zone und einer Drain-Zone des ersten Leitfähigkeitstyps (N oder P) des CMOS-Transistors gebildet wird.

11. Verfahren nach Anspruch 9, bei dem die Source-Zone des DMOS-Transistors unter Einsatz eines Schritts zur Bildung einer Emitterzone des ersten Leitfähigkeitstyps (N) des Bipolartransistors gebildet wird.

12. Verfahren nach einem der Ansprüche 1 bis 5, bei dem die Halbleitervorrichtung des weiteren eine BiCMOS-Halbleitervorrichtung umfaßt, die CMOS-Transistoren und einen Bipolartransistor enthält, die auf einem gemeinsamen Substrat mit dem DMOS-Transistor gebildet sind, und bei dem die Source-Zone des DMOS-Transistors unter Einsatz eines Schritts zur Bildung einer Basiszone des zweiten Leitfähigkeitstyps (P) des Bipolartransistors gebildet wird.

13. Verfahren nach Anspruch 12, bei dem die Source-Zone des DMOS-Transistors unter Einsatz eines Schritts zur Bildung einer Emitterzone des zweiten Leitfähigkeitstyps des Bipolartransistors gebildet wird.

14. Verfahren nach einem der Ansprüche 6 bis 13, bei dem eine Ionenimplantation zur Bildung der Source-Zone als P⁺-Zone und der Drain-Zone als P⁺-Zone des CMOS-Transistors ausgeführt wird, wonach eine Ionenimplantation zur Bildung der Source-Zone als N⁻-Zone und der Drain-Zone als N⁺-Zone des CMOS-Transistors ausgeführt wird.

15. Verfahren nach einem der Ansprüche 6 bis 14, bei dem die Basiszone des DMOS-Transistors durch Implantieren von Ionen mit einer Dosismenge von 5 x 10¹⁴ cm⁻² oder weniger gebildet wird.

## Revendications

1. Procédé de fabrication d'un dispositif à semi-conducteur. comportant un transistor DMOS ayant un canal d'un premier type de conductivité (N ou P) comportant les étapes suivantes pour former le transistor DMOS qui consistent à :
(a) former une électrode (10) de grille sur une pellicule d'isolation de grille déposée sur une région (5) à semi-conducteur d'un second type de conductivité (P ou N) ;
(b) former une région (21, 27) de base du second type de conductivité (P ou N) en utilisant l'électrode de grille en tant qu'un masque pour l'autoalignement;
(c) former des parois (25) latérales sur les faces latérales de l'électrode de grille ; et
(d) former une région (26_{NS}, 22_{PS}) formant source du premier type de conductivité (N ou P) à partir d'une face principale de la région de base en utilisant les parois latérales en tant qu'un masque pour l'autoalignement,
dans lequel l'étape (c) comprend le fait de former les parois (25) latérales par oxydation thermique mettant en jeu un traitement thermique suffisant pour pénétrer dans la région de base.

2. Procédé de fabrication d'un dispositif à semi-conducteur, comportant un transistor DMOS ayant un canal d'un premier type de conductivité (N ou P) comportant les étapes suivantes pour former le transistor DMOS qui consistent à :
(a) former une électrode (10) de grille sur une pellicule d'isolation de grille déposée sur une région (5) à semi-conducteur d'un second type de conductivité (P ou N) ;
(b) former une région (21, 27) de base du second type de conductivité (P ou N) en utilisant l'électrode de grille en tant qu'un masque pour l'autoalignement;
(c) former des parois (25) latérales sur des faces latérales de l'électrode de grille ; et
(d) former une région (26_{NS}, 22_{PS}) de source du premier type de conductivité (N ou P) à partir d'une face principale de la région de base en utilisant les parois latérales en tant qu'un masque pour l'autoalignement.
dans lequel l'étape (c) comprend le fait de former les parois (25) latérales par un procédé de dépôt chimique en phase vapeur sous pression réduite mettant en jeu un traitement thermique suffisant pour pénétrer la région de base.

3. Procédé suivant la revendication 1 ou la revendication 2, comportant en outre l'étape qui consiste à former une couche (8) à implantation ionique formant canal en implantant des ions d'impureté de type P dans la région de surface principale de la région (5) à semi-conducteur.

4. Procédé suivant la revendication 1, 2 ou 3 comportant en outre l'étape qui consiste à former, en tant que la région (5) à semi-conducteur du transistor DMOS, un puits (5) du second type de conductivité dans une région (3) à semi-conducteur du premier type de conductivité.

5. Procédé suivant la revendication 3 et la revendication 4, dans lequel la couche (8) d'implantation ionique formant canal est formée en implantant des ions d'impureté de type P à partir de la face principale du puits (5).

6. Procédé suivant l'une quelconque des revendications 1 à 5. dans lequel le dispositif à semi-conducteur comprend en outre un dispositif à semi-conducteur CMOS comportant des transistors CMOS dans une structure LDD formés sur un substrat (1) commun avec le transistor DMOS et ayant des parois (25) latérales sur les deux faces latérales de son électrode (10) de grille, et les parois (25) latérales du transistor DMOS sont formées en utilisant une étape pour former les parois (25) latérales du transistor CMOS.

7. Procédé suivant les revendications 4 et 6, dans lequel le puits (5) du transistor DMOS est formé en utilisant une étape pour former un puits du second type de conductivité (P) du transistor CMOS.

8. Procédé suivant la revendication 6 ou 7, dans lequel la région (21, 27) de base du transistor DMOS est formée en utilisant une étape pour former une région de source et une région de drain du second type de conductivité (P ou N) du transistor CMOS.

9. Procédé suivant l'une quelconque des revendications 1 à 8, dans lequel le dispositif à semi-conducteur comprend en outre un dispositif à semi-conducteur BiCMOS comportant des transistors CMOS et un transistor bipolaire formés sur un substrat commun avec le transistor DMOS. et la région de base du transistor DMOS est formée en utilisant une étape pour former une région de base du second type de conductivité (P) du transistor bipolaire.

10. Procédé suivant les revendications 6 à 9, dans lequel la région de source du transistor DMOS est formée en utilisant une étape pour former une région de source et une région de drain du premier type de conductivité (N ou P) du transistor CMOS.

11. Procédé suivant la revendication 9, dans lequel la région de source du transistor DMOS est formée en utilisant une étape pour former une région d'émission du premier type de conductivité (N) du transistor bipolaire.

12. Procédé suivant l'une quelconque des revendications 1 à 5. dans lequel le dispositif à semi-conducteur comprend en outre un dispositif à semi-conducteur BiCMOS comportant des transistors CMOS et un transistor bipolaire formés sur un substrat commun avec le transistor DMOS, et la région de source du transistor DMOS est formée en utilisant une étape pour former une région de base du second type de conductivité (P) du transistor bipolaire.

13. Procédé suivant la revendications 12, dans lequel la région de source du transistor DMOS est formée en utilisant une étape pour former une région d'émission du second type de conductivité du transistor bipolaire.

14. Procédé suivant l'une quelconque des revendications 6 à 13. dans lequel l'implantation ionique est effectuée pour former la région de source d'un type P⁺ et la région de drain du type P⁺ du transistor CMOS. et ensuite l'implantation ionique est effectuée pour former la région de source d'un type N⁺ et la région de drain du type N⁺ du transistor CMOS.

15. Procédé suivant l'une quelconque des revendications 6 à 14. dans lequel la région de base du transistor DMOS est formée en implantant des ions à une quantité de dose de 5 x 10¹⁴ cm⁻² ou moins.
